# EUROPÄISCHE PATENTSCHRIFT

(11) **EP 2 564 428 B1**
(45) Veröffentlichungstag und Bekanntmachung des Hinweises auf die Patenterteilung: **11.03.2015**
(21) Anmeldenummer: 11721697.8
(22) Anmeldetag: 20.04.2011
(51) Int. Cl.: H01L 31/048, H01L 31/05, H01L 31/02

(54) **Verfahren zum Kontaktieren eines photovoltaischen Moduls mit einem Anschlussgehäuse sowie System bestehend aus einem photovoltaischen Modul und einem Anschlussgehäuse**
Method for contact-connecting a photovoltaic module to a connection housing and system consisting of a photovoltaic module and a connection housing
Procédé d'établissement des contacts entre un module photovoltaïque et un boîtier de raccordement, ainsi que système composé d'un module photovoltaïque et d'un boîtier de raccordement

(30) Priorität: 27.04.2010 AT 27010 U
(43) Veröffentlichungstag der Anmeldung: 06.03.2013
(73) Patentinhaber: AT & S Austria Technologie & Systemtechnik Aktiengesellschaft, 8700 Leoben-Hinterberg (AT)
(72) Erfinder: OBERRISSER, Patrick, A-8750 Judenburg (AT); GMUNDNER, Gernot, A-8714 Kraubath (AT)
(74) Vertreter: Miksovsky, Alexander
(86) Internationale Anmeldenummer: PCT/AT2011/000192
(87) Internationale Veröffentlichungsnummer: WO 2011/133992

(56) Entgegenhaltungen:
- EP-A1- 2 113 945
- EP-A2- 0 867 947
- DE-U1-202009 012 176
- DE-U1-202010 000 052

## Beschreibung

Die vorliegende Erfindung bezieht sich auf ein Verfahren zum Kontaktieren eines photovoltaischen Moduls mit einem Anschlussgehäuse bzw. einer Junction Box, wobei zur Herstellung des photovoltaischen Moduls wenigstens eine Solarzelle an einer Rückseite mit einer elektrisch leitenden bzw. leitfähigen und strukturierten Schicht zur Ableitung der in der Solarzelle erzeugten elektrischen Energie gekoppelt wird und an der von der elektrisch leitenden Schicht abgewandten Oberfläche der Solarzelle wenigstens eine transparente Trägerschicht und an der elektrisch leitenden Schicht eine Abdeckschicht vorgesehen werden, wobei nachfolgend die elektrisch leitende und strukturierte Schicht mit Anschlüssen des Anschlussgehäuses kontaktiert wird, wobei nach der Fertigstellung des photovoltaischen Moduls beispielsweise durch ein Verpressen der und/oder eine Wärmeeinwirkung auf die das photovoltaischen Modul bildenden Schichten bzw. Elemente in der Abdeckschicht wenigstens eine Durchtrittsöffnung für ein Freilegen von Teilbereichen unterschiedlicher Polarität der strukturierten leitenden Schicht ausgebildet wird und Anschlüsse oder Anschlusselemente des Anschlussgehäuses direkt mit den Teilbereichen unterschiedlicher Polarität der strukturierten leitenden Schicht gekoppelt werden. Die vorliegende Erfindung bezieht sich darüber hinaus auf ein System bestehend aus einem photovoltaischen Modul und einem Anschlussgehäuse bzw. einer Junction Box, wobei das photovoltaische Modul wenigstens eine Solarzelle umfasst, welche an einer Rückseite mit einer elektrisch leitenden bzw. leitfähigen und strukturierten Schicht zur Ableitung der in einer Solarzelle erzeugten elektrischen Energie gekoppelt ist, und darüber hinaus an der von der elektrisch leitenden Schicht abgewandten Oberfläche der Solarzelle wenigstens eine transparente Trägerschicht und an der elektrisch leitenden Schicht eine Abdeckschicht vorgesehen sind, wobei die elektrisch leitende und strukturierte Schicht mit Anschlüssen des Anschlussgehäuses kontaktierbar ist, wobei Anschlüsse oder Anschlusselemente des Anschlussgehäuses direkt mit Teilbereichen unterschiedlicher Polarität der strukturierten leitenden Schicht über wenigstens eine Durchtrittsöffnung in der Abdeckschicht koppelbar sind.

Ein derartiges, sogenanntes rückseitenkontaktiertes photovoltaisches Modul besteht aus wenigstens einer Solarzelle, wobei die Solarzelle an einer Rückseite mit einer elektrisch leitenden bzw. leitfähigen und strukturierten Schicht zur Ableitung der in der Solarzelle elektrischen Energie gekoppelt bzw. koppelbar ist. Zusätzlich werden an der von der elektrisch leitenden Schicht abgewandten Oberfläche der Solarzelle und somit zu der Strahlungsquelle gerichtet wenigstens eine transparente Trägerschicht und an der elektrisch leitenden Schicht eine Abdeckschicht vorgesehen.

Zur Ableitung der in der Solarzelle erzeugten elektrischen Energie, wobei üblicherweise eine Mehrzahl von Solarzellen in einem gemeinsamen Trägerelement über die elektrisch leitende bzw. leitfähige und strukturierte Schicht gekoppelt wird, erfolgt nachfolgend eine Kontaktierung mit Anschlüssen des Anschlussgehäuses. Gemäß bekannten Ausführungsformen werden in der Abdeckschicht Schlitze für ein Durchleiten von Kontakt- bzw. Lötbändchen erzeugt, welche mit Teilbereichen der elektrisch leitenden und strukturierten Schicht in aufwendigen Verfahrensschritten verbunden werden. Nach einer Anordnung des Anschlussgehäuses bzw. der Junction Box wird eine wiederum aufwendige Kontaktierung bzw. Verdrahtung zwischen den durch den Schlitz in der Abdeckschicht des photovoltaischen Moduls hindurchgeführten Kontakt- bzw. Lötbändchen und entsprechenden Kontakten des Anschlussgehäuses vorgenommen. Ein derartiges Verfahren sowie ein derartiges System sind beispielsweise der US-B 6 469 242 zu entnehmen, woraus insbesondere ersichtlich ist, dass durch die Ausbildung von Schlitzen und entsprechenden Durchbrechungen zur Durchführung der Lötbändchen nicht nur ein für die herzustellende Kontaktierung überaus hoher Arbeitsaufwand erforderlich ist, sondern auch die für eine ordnungsgemäße Funktionsweise erforderliche Dichtheit des photovoltaischen Moduls nicht zuverlässig sichergestellt werden kann.

Ein Verfahren sowie ein System der eingangs genannten Art sind beispielsweise der EP 2 113 945 A1 zu entnehmen, wobei zur Bereitstellung einer Kontaktierung einer Solarzelle nach einem Laminieren ein einem Kontaktbereich von elektrisch leitenden Verbindern entsprechender Bereich einer Abdeckschicht abgetragen wird und der Kontaktbereich mit einem außenliegenden Anschlusselement gekoppelt wird. Die elektrischen Verbinder werden hierbei aufwendig durch ein Koppeln einer Mehrzahl von Längs- und Querverbindern vor einem Überdecken mit wenigstens einer zusätzlichen Abdeckschicht bereitgestellt bzw. vorbereitet.

Aus der EP 0 867 947 Ä2 ist eine weitere abgewandelte Ausführungsform eines Anschlusses für ein photovoltaisches Modul bekannt geworden.

Die vorliegende Erfindung zielt darauf ab, die Probleme des oben genannten Standes der Technik zu vermeiden und somit ein Verfahren zum Kontaktieren eines photovoltaischen Moduls mit einem Anschlussgehäuse bzw. einer Junction Box als auch ein aus einem photovoltaischen Modul und einem Anschlussgehäuse bestehendes System zur Verfügung zu stellen, bei welchen insbesondere mit vereinfachten Verfahrensschritten eine zuverlässige und einfache Kontaktierung zwischen der elektrisch leitenden und strukturierten Schicht des photovoltaischen Moduls und entsprechenden Kontakten bzw. Anschlüssen oder Anschlusselementen des Anschlussgehäuses bzw. der Junction Box bereitgestellt werden kann.

Zur Lösung dieser Aufgaben ist ein Verfahren der eingangs genannten Art im wesentlichen dadurch gekennzeichnet, dass die elektrisch leitende und strukturierte Schicht und die Abdeckschicht von einer Verbundfolie gebildet werden, welche mit der Solarzelle verbunden bzw. gekoppelt wird. Da nach der Fertigstellung des photovoltaischen Moduls wenigstens eine Durchtrittsöffnung in der Abdeckschicht desselben für ein Freilegen von Teilbereichen unterschiedlicher Polarität der strukturierten leitenden Schicht des photovoltaischen Moduls ausgebildet wird und Anschlüsse oder Anschlusselemente des Anschlussgehäuses direkt mit den Teilbereichen unterschiedlicher Polarität gekoppelt werden, wird gegenüber bekannten Verfahren und Systemen, wonach beispielsweise eine Kontaktierung über mehrfach zu kontaktierende und durch entsprechende Schlitze im photovoltaischen Modul hindurchzuführende Lötbändchen erfolgte, eine stark vereinfachte und zuverlässigere Kontaktierung zur Verfügung gestellt. Darüber hinaus kann durch einen Verzicht auf eine Ausbildung von Schlitzen zumindest der Abdeckschicht und üblicherweise weiterer Schichten des

photovoltaischen Moduls auch sichergestellt werden, dass die Dichtheit des photovoltaischen Moduls insbesondere im Bereich der Kontaktierung mit Anschlüssen des Anschlussgehäuses nicht beeinträchtigt wird. Zur weiteren Verbesserung eines insbesondere dichten Aufbaus des photovoltaischen Moduls und zur Vereinfachung der Kontaktierung mit Anschlüssen oder Anschlusselementen des Anschlussgehäuses wird erfindungsgemäß vorgeschlagen, dass die elektrisch leitende und strukturierte Schicht und die Abdeckschicht von einer Verbundfolie gebildet werden, welche mit der Solarzelle verbunden bzw. gekoppelt wird. Erfindungsgemäß wird lediglich in der Abdeckschicht wenigstens eine Durchtrittsöffnung zur Freilegung von Teilbereichen unterschiedlicher Polarität der strukturierten leitenden Schicht vorgesehen, wobei durch die Schicht aus leitendem bzw. leitfähigem Material, welche mit weiteren Schichten bzw. Lagen des photovoltaischen Moduls entsprechend beispielsweise durch ein Verpressen und/oder eine Wärmeeinwirkung verbunden wird, die erforderliche Dichtheit des gesamten photovoltaischen Moduls insbesondere gegenüber einem Eindringen beispielsweise von Feuchtigkeit zuverlässig aufrecht erhalten werden kann. Es lässt sich somit durch das erfindungsgemäße Verfahren nicht nur die Kontaktierung zwischen der elektrisch leitenden bzw. leitfähigen und strukturierten Schicht des photovoltaischen Moduls und Anschlüssen bzw. Kontakten oder Anschlusselementen des Anschlussgehäuses vereinfacht und rasch durchführen, sondern es wird auch die für eine ordnungsgemäße Funktionsweise des photovoltaischen Moduls erforderliche Dichtheit insbesondere ohne zusätzliche Maßnahmen bzw. Vorkehrungen zuverlässig aufrecht erhalten. Durch die erfindungsgemäß vorgeschlagene Verwendung einer Verbundfolie lässt sich auch die Bereitstellung der strukturierten leitfähigen Schicht vereinfachen.

Für eine besonders einfache Ausbildung der wenigstens einen Durchtrittsöffnung in der Abdeckschicht des photovoltaischen Moduls wird gemäß einer bevorzugten Ausführungsform vorgeschlagen, dass die wenigstens eine Durchtrittsöffnung durch ein mechanisches Entfernen eines Teilbereichs der Abdeckschicht, ein Fräsen, ein Ätzen oder dgl. freigelegt wird. Derartige Verfahren zum Ausbilden einer Durchtrittsöffnung in einer gegebenenfalls eine geringe Dicke aufweisenden Schicht bzw. Lage können entsprechend zuverlässig und genau sowie schonend durchgeführt werden, um eine Beeinträchtigung insbesondere der Dichtheit des photovoltaischen Moduls in umgebenden Bereichen der Durchtrittsöffnung im Gegensatz zu bekannten Ausführungsformen, wonach schlitzartige Durchbrechungen üblicherweise durch eine Mehrzahl von Schichten bzw. Lagen ausgebildet werden, zu vermeiden.

Gemäß einer besonders bevorzugten Ausführungsform wird hierbei vorgeschlagen, dass das Ätzen unter Einsatz eines Lasers durchgeführt wird, wobei insbesondere in Abhängigkeit von dem Material der Abdeckschicht des photovoltaischen Moduls beispielsweise ein UV-Laser oder CO₂-Laser verwendet werden kann.

Für ein nachfolgend einfaches und zuverlässiges Kontaktieren bzw. Koppeln zwischen den Teilbereichen unterschiedlicher Polarität der elektrisch leitenden und strukturierten Schicht des photovoltaischen Moduls und entsprechenden Kontakten bzw. Anschlüssen des Anschlussgehäuses wird darüber hinaus vorgeschlagen, dass ein direktes Kontaktieren mit Anschlüssen oder Anschlusselementen des Anschlussgehäuses durch ein Verlöten, Verkleben, oder dgl. durchgeführt wird, wie dies einer weiters bevorzugten Ausführungsform des erfindungsgemäßen Verfahrens entspricht.

Zur Bereitstellung eines dichten Abschlusses des photovoltaischen Moduls sowie zur einfachen Durchführung insbesondere von Verfahrensschritten bei der Herstellung des photovoltaischen Moduls wird gemäß einer weiters bevorzugten Ausführungsform vorgeschlagen, dass die Abdeckschicht von mindestens einer Kunststoffschicht, beispielsweise einer Polyvinylfluoridfolie, gebildet wird.

Während bei bekannten Ausführungsformen für ein Kontaktieren der aufwendig einzusetzenden Kontakt- bzw. Lötbändchen mit Kontakten des Anschlussgehäuses ein überaus großer herstellungstechnischer Aufwand verbunden war, wird gemäß einer weiters bevorzugten Ausführungsform vorgeschlagen, dass die Positionierung des Anschlussgehäuses auf der Abdeckschicht nach Ausbildung der wenigstens einen Durchtrittsöffnung automatisiert vorgenommen wird. Derart lässt sich der Aufwand für die Kontaktierung des Anschlussgehäuses gegenüber bekannten Verfahrensführungen entsprechend stark reduzieren.

Zur Lösung der eingangs genannten Aufgaben ist darüber hinaus ein System bestehend aus einem photovoltaischen Modul und einem Anschlussgehäuse bzw. einer Junction Box gemäß der eingangs genannten Art im wesentlichen dadurch gekennzeichnet, dass die elektrisch leitende Schicht und die Abdeckschicht von einer Verbundfolie gebildet sind. Durch Bereitstellung der wenigstens einen Durchtrittsöffnung unter Freilegung von Teilbereichen unterschiedlicher Polarität der strukturierten leitenden Schicht lässt sich somit, wie oben bereits ausgeführt, eine besonders einfache und zuverlässige Kontaktierung mit Kontakten bzw. Anschlüssen oder Anschlusselementen des Anschlussgehäuses zur Verfügung stellen. Darüber hinaus wird die für eine ordnungsgemäße Funktionsweise des photovoltaischen Moduls erforderliche Dichtheit des mehrlagigen bzw. mehrschichtigen Aufbaus ebenfalls sichergestellt bzw. zuverlässig aufrecht erhalten. Für eine besonders zuverlässige und einfache Herstellung des photovoltaischen Moduls bei gleichzeitiger Ermöglichung einer zuverlässigen Kontaktierung mit Anschlüssen oder Anschlusselementen des Anschlussgehäuses wird hierbei erfindungsgemäß vorgeschlagen, dass die elektrisch leitende Schicht und die Abdeckschicht von einer Verbundfolie gebildet sind.

Für eine besonders einfache und zuverlässige Kontaktierung bzw. Kopplung zwischen Anschlüssen bzw. Kontakten oder Anschlusselementen des Anschlussgehäuses und den Teilbereichen der strukturierten leitenden Schicht wird darüber hinaus vorgeschlagen, dass die Anschlüsse des Anschlussgehäuses mit jeweils einem leitenden Element koppelbar sind, welches insbesondere über eine Klebe- bzw. Lötverbindung mit jeweils einem Teilbereich unterschiedlicher Polarität der strukturierten leitenden Schicht durch die Durchtrittsöffnung kontaktierbar und damit koppelbar ist, wie dies einer weiters bevorzugten Ausführungsform des erfindungsgemäßen Systems entspricht. Derart lässt sich, wie oben bereits angedeutet, der Verbindungsvorgang zwischen dem photovoltaischen Modul und Kontakten bzw. Anschlüssen oder Anschlusselementen des Anschlussgehäuses vereinfachen und günstigerweise weitestgehend automatisieren.

Für eine besonders zuverlässige Kontaktierung insbesondere unter Vermeidung von entsprechend aufwendig einzusetzenden zusätzlichen Elementen wird gemäß einer weiters bevorzugten Ausführungsform vorgeschlagen, dass das leitende Element von einem aus einem leitenden Material gebildeten Element, insbesondere einem Lötbändchen, oder dgl. gebildet ist.

Zur weiteren Verringerung der Bauteile bzw. Einzelelemente insbesondere des Anschlussgehäuses und zur Vermeidung von Verlusten bei der Energieübertragung über eine große Anzahl von Verbindungsstellen wird gemäß einer weiters bevorzugten Ausführungsform vorgeschlagen, dass die Anschlüsse des Anschlussgehäuses direkt mit jeweils einem Teilbereich unterschiedlicher Polarität der strukturierten leitenden Schicht durch die Durchtrittsöffnung kontaktierbar und damit koppelbar sind.

Für eine zuverlässige Festlegung des Anschlussgehäuses an dem photovoltaischen Modul und darüber hinaus zur Bereitstellung einer entsprechenden Abdichtung im Bereich des Anschlussgehäuses wird gemäß einer weiters bevorzugten Ausführungsform vorgeschlagen, dass das Anschlussgehäuse an dem photovoltaischen Modul dichtend, insbesondere über eine Verklebung festlegbar ist.

Die Erfindung wird nachfolgend anhand von in der beiliegenden Zeichnung schematisch dargestellten Ausführungsbeispielen näher erörtert. In dieser zeigen:
Fig. 1 einen schematischen Schnitt durch ein System bestehend aus einem photovoltaischen Modul und einem Anschlussgehäuse gemäß dem bekannten Stand der Technik;
Fig. 2 in einer zu Fig. 1 ähnlichen Darstellung einen Schnitt durch ein erfindungsgemäßes System bestehend aus einem photovoltaischen Modul und einem Anschlussgehäuse, welches gemäß dem erfindungsgemäßen Verfahren hergestellt wurde;
Fig. 3 eine schematische Draufsicht auf das in Fig. 2 dargestellte System entsprechend dem Pfeil III der Fig. 2;
Fig. 4 in einer zu Fig. 2 wiederum ähnlichen Darstellung eine weitere abgewandelte Ausführungsform eines erfindungsgemäßen Systems;
Fig. 5 in einer Darstellung ähnlich Fig. 4 eine neuerlich abgewandelte Ausführungsform eines erfindungsgemäßen Systems mit einer unmittelbaren Kopplung von Anschlüssen eines Anschlussgehäuses an die leitende, strukturierte Schicht; und
Fig. 6 ein schematisches Flussdiagramm des erfindungsgemäßen Verfahrens zum Kontaktieren eines photovoltaischen Moduls mit einem Anschlussgehäuse.

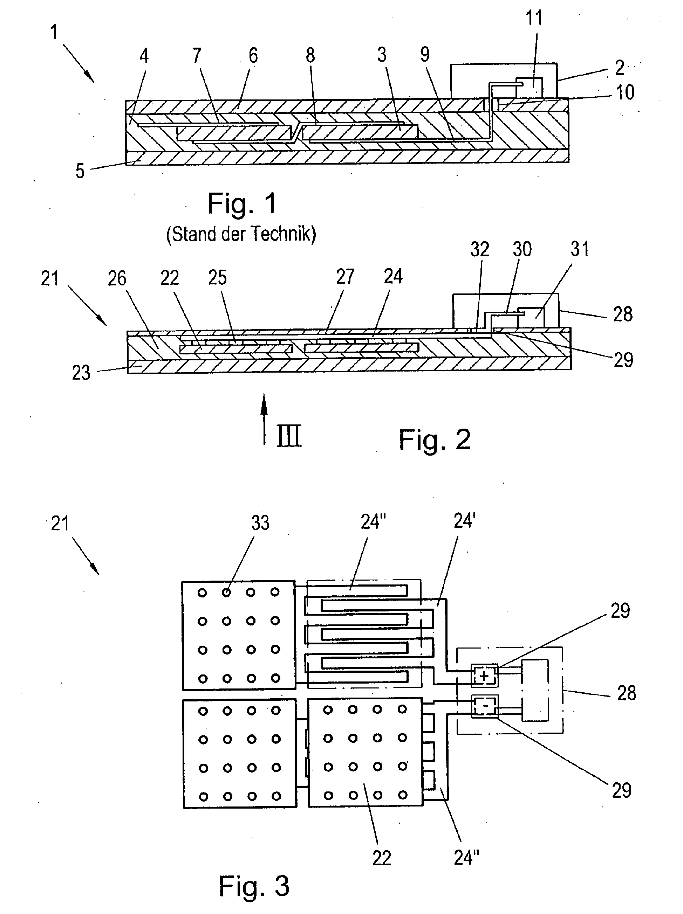

In Fig. 1 ist ein schematischer Schnitt durch ein bekanntes photovoltaisches Modul 1 sowie ein darauf festgelegtes Anschlussgehäuse bzw. eine Junction Box 2 dargestellt, wobei ersichtlich ist, dass jeweils eine Mehrzahl von Zellen bzw. Solarzellen 3 in mindestens einer Kunststoffschicht 4, beispielsweise bestehend aus Ethylenvinylacetat, eingebettet ist. Zusätzlich sind eine zu einer nicht näher dargestellten Strahlungsquelle gerichtete transparente Trägerschicht 5, welche beispielsweise aus Glas besteht, und eine Abdeckschicht 6 vorgesehen.

Die benachbarten Zellen 3 sind in Serie geschaltet und über Kontaktbahnen 7 und 8 miteinander verbunden. Für eine Kopplung mit einem an der Abdeckschicht 6 in weiterer Folge festzulegenden Anschlussgehäuse 2 werden zusätzlich Kontakt- bzw. Lötbändchen 9 vorgesehen, welche eine schlitzförmige Öffnung bzw. einen Schnitt 10 in der Abdeckschicht 6 durchdringen und jeweils mit einem schematisch angedeuteten Anschluss bzw. Kontakt 11 im Anschlussgehäuse 2 kontaktiert werden. Durch Ausbilden des Schlitzes bzw. Schnitts 10, welcher nicht nur die Abdeckschicht 6 sondern auch die zur Einbettung vorgesehene Kunststoffschicht 4 wenigstens teilweise durchdringt, besteht bei derartigen bekannten Ausführungsformen gemäß dem Stand der Technik nicht nur ein Problem im Hinblick auf die erforderliche Dichtheit des photovoltaischen Moduls 1, sondern auch ein erhöhter Aufwand zur Kontaktierung mit den Kontakten 11 des Anschlussgehäuses 2.

Auch für lediglich an ihrer Rückseite kontaktierte Solarzellen ist im Stand der Technik für eine Ableitung der erzeugten Energie die Durchführung von Lötbändchen durch Schnitte bzw. Schlitze 10, welche die Abdeckschicht 6 als auch wenigstens teilweise die Schicht 4 durchdringen, mit den oben erwähnten Nachteilen vorgesehen.

In Fig. 2 und 3 sind eine Schnittansicht ähnlich der Darstellung gemäß Fig. 1 als auch eine Draufsicht auf ein erfindungsgemäßes System gezeigt, wobei insbesondere aus der Darstellung gemäß Fig. 3 ersichtlich ist, dass das photovoltaische Modul 21 eine Mehrzahl von Zellen bzw. Solarzellen 22 enthält. Die Solarzellen 22 werden jeweils an ihrer von einer transparenten Schicht 23, welche aus Glas hergestellt sein kann, abgewandten Oberfläche bzw. Rückseite mit einer strukturierten elektrisch leitenden bzw. leitfähigen Schicht 24 über schematisch angedeutete Kontakte 25 kontaktiert. Darüber hinaus sind in Fig. 3 schematisch mit 33 Kontakte bzw. Kontaktstellen angedeutet, welche eine Kontaktierung durch die Solarzellen 22 mit der an der Rückseite derselben angeordneten leitenden und strukturierten Schicht 24 ermöglichen.

Die Strukturierung der leitenden bzw. leitfähigen Schicht 24 ist insbesondere aus dem rechten oberen Teilbereich der Darstellung gemäß Fig. 3 ersichtlich, wobei gezeigt ist, dass im wesentlichen zinken- bzw. gabelartige ineinander greifende Elemente der strukturierten Schicht jeweils unterschiedliche Polarität aufweisen, wie dies durch die Anschlussstellen + bzw. - angedeutet ist. Die Teilbereiche unterschiedlicher Polarität sind in Fig. 3 schematisch mit 24' und 24" angedeutet.

Ebenso wie bei der Ausführungsform gemäß dem Stand der Technik gemäß Fig. 1 sind die Solarzellen 22 in einem Kunststoffmaterial bzw. einer Kunststoffschicht 26 eingebettet, welche beispielsweise aus Ethylenvinylacetat besteht.

Darüber hinaus ist an der von der transparenten Basisschicht 23, welche wiederum zu einer nicht gezeigten Strahlungsquelle gerichtet ist, abgewandten Seite eine Abdeckschicht 27 vorgesehen, welche beispielsweise aus einer Polyvinylfluoridfolie besteht.

Für eine einfache Bereitstellung der elektrisch leitenden bzw. leitfähigen Schicht 24 kann darüber hinaus vorgesehen sein, dass eine Verbundfolie, bestehend aus der Abdeckschicht 27 und der strukturierten, elektrisch leitenden Schicht 24, zur Verfügung gestellt wird, wobei die Verbundfolie entweder unmittelbar mit der strukturierten leitenden bzw. leitfähigen Schicht entsprechend den Bahnen 24' und 24" ausgebildet ist oder eine derartige Strukturierung auf der im wesentlichen vollflächigen leitenden bzw. leitfähigen Schicht nach Bereitstellung der Verbundfolie beispielsweise mit bekannten Ätzverfahren hergestellt wird.

Für eine Kontaktierung eines Anschlussgehäuses 28 mit den Teilbereichen + bzw. - unterschiedlicher Polarität werden in der Abdeckschicht 27 Durchtrittsöffnungen 29 ausgebildet, welche unmittelbar bei den Teilbereichen unterschiedlicher Polarität + bzw. - der strukturierten leitenden Schicht 24' und 24" münden.

Im Bereich der Durchtrittsöffnungen 29 erfolgt eine unmittelbare bzw. direkte Kontaktierung mit Anschlusselementen 30 des Anschlussgehäuses 28, welches Anschlüsse bzw. Kontakte 31 aufweist.

Es kann somit das Anschlussgehäuse 28 neben den Kontakten 31 unmittelbar mit den Anschlusselementen 30 zur Verfügung gestellt werden, wobei freie Enden 32 der Anschlusselemente 31 direkt in die Durchtrittsöffnungen 29 eintreten und mit den Bereichen unterschiedlicher Polarität + bzw. - der strukturierten leitenden Schicht 24' und 24" kontaktiert werden.

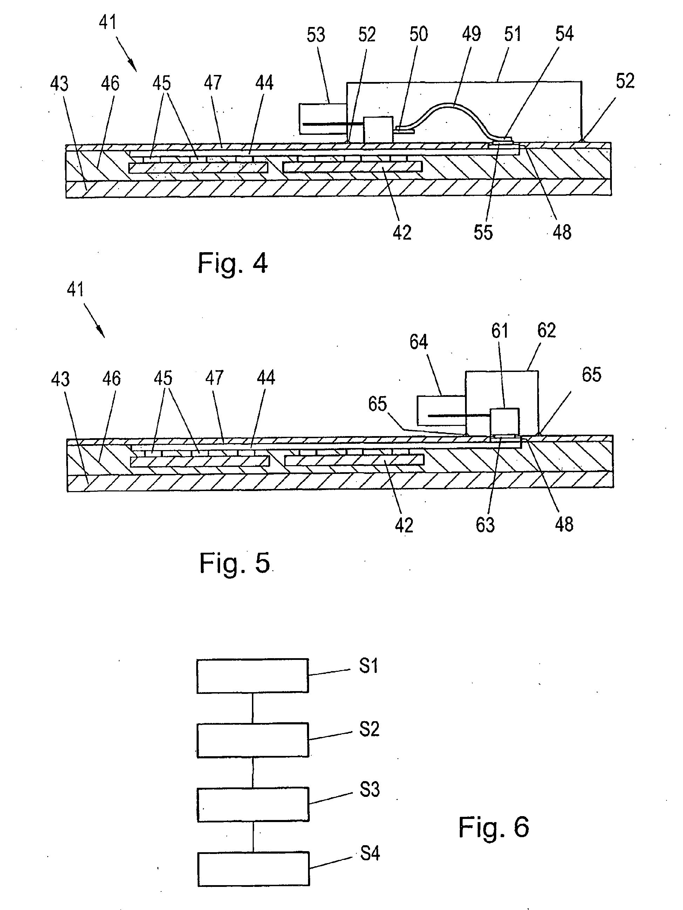

Ein derartiges Kontaktieren kann beispielsweise durch eine Lötverbindung erfolgen, wie dies insbesondere unter Bezugnahme auf Fig. 5 im Detail erörtert werden wird.

Bei der abgewandelten Ausführungsform gemäß Fig. 4 besteht ein photovoltaisches Modul 41 wiederum aus einer Mehrzahl von Zellen 42, wobei eine transparente Basis- bzw. Trägerschicht mit 43 bezeichnet ist. Die Zellen 42 sind mit einer an der Rückseite und somit von der transparenten Schicht 43 abgewandten Seite angeordneten strukturierten und leitenden Schicht 44 über schematisch angedeutete Kontakte 45 verbunden, wobei die Solarzellen 42 wiederum in einer Kunststoffschicht 46 eingebettet sind. Die die Zellen 42 durchdringenden Kontakte sind ähnlich wie bei der Darstellung gemäß Fig. 2 nicht gezeigt. An der von der Trägerschicht 43 abgewandten Seite ist wiederum eine Abdeckschicht 47 vorgesehen.

Für eine Kontaktierung erfolgt auch bei der in Fig. 4 dargestellten Ausführungsform eine Ausbildung von wenigstens einer Durchtrittsöffnung 48 in der Abdeckschicht 47 zur Freilegung von Teilbereichen unterschiedlicher Polarität der strukturierten leitenden bzw. leitfähigen Schicht 44. Bei der Ausführungsform gemäß Fig. 4 ist das Anschlusselement wiederum von einem in das Anschlussgehäuse 51 integrierten Lötbändchen 49 gebildet, welches wiederum mit einem schematisch angedeuteten Kontakt 50 ähnlich wie bei der vorangehenden Ausführungsform verbunden ist. Das Anschlussgehäuse 51 wird über schematisch angedeutete Verklebungen 52 an der Abdeckschicht 47 festgelegt, wobei zusätzlich beispielsweise ein Steckverbinder des Anschlussgehäuses 51 schematisch mit 53 angedeutet ist.

Im Bereich der wenigstens einen Durchtrittsöffnung 48 ist ergänzend für eine Kontaktierung zwischen dem freien Ende 54 und einem entsprechenden Teilbereich unterschiedlicher Polarität der strukturierten Schicht 44 ein Klebematerial oder ein Lötmaterial 55 angedeutet.

Bei der Darstellung gemäß Fig. 5 sind für gleiche Elemente bzw. Bauteile die Bezugszeichen der Fig. 4 beibehalten worden. Derart besteht ein photovoltaisches Modul 41 aus einer Mehrzahl von Solarzellen 42, wobei zusätzlich eine transparente Basis- bzw. Trägerschicht 43 vorgesehen ist. Eine Kontaktierung der Zellen 42 erfolgt mit einer strukturierten und leitenden Schicht 44 über schematische Kontakte 45, wobei eine Kunststoffschicht 46 zur Einbettung der Solarzellen 42 vorgesehen ist. Eine Abdeckschicht 47 ist zur Freilegung von Teilbereichen unterschiedlicher Polarität der strukturierten bzw. leitenden Schicht 44 wiederum mit wenigstens einer Durchtrittsöffnung 48 versehen.

Anstelle einer Verwendung von Anschlusselementen aus einem leitenden Material gemäß den Ausführungsformen von Fig. 2 und 4 ist bei der Ausbildung gemäß Fig. 5 vorgesehen, dass Anschlüsse bzw. Kontakte 61 eines Anschlussgehäuses 62 direkt mit den Teilbereichen unterschiedlicher Polarität der Schicht 44 über eine Verklebung bzw. Verlötung 63 kontaktiert bzw. verbunden sind. Ähnlich wie bei der Ausführungsform gemäß Fig. 4 ist auch für das Anschlussgehäuse 62 ein Steckverbinder 64 vorgesehen bzw. angedeutet.

Für eine Festlegung des Anschlussgehäuses 62 an der Abdeckschicht 47 sind schematisch angedeutete Verklebungen 65 vorgesehen.

Durch die unmittelbare Kontaktierung bei der Ausführungsform gemäß Fig. 5 zwischen den freigelegten Teilbereichen unterschiedlicher Polarität über die Durchtrittsöffnungen 48 und den Anschlüssen bzw. Kontakten 61 des Anschlussgehäuses 62 kann somit der Aufwand für eine Kontaktierung bzw. Kopplung zwischen dem photovoltaischen Modul 41 und dem Anschlussgehäuse 62 weiter verringert bzw. vereinfacht werden.

Aufgrund der Tatsache, dass bei den Ausführungsformen gemäß Fig. 2, 4 und 5 lediglich im Bereich von Anschlussstellen unterschiedlicher Polarität der leitenden und strukturierten Schicht 24 bzw. 44 wenigstens eine Durchtrittsöffnung 29 bzw. 48 in der Abdeckschicht 27 bzw. 47 ausgebildet wird, wird die Integrität des photovoltaischen Moduls 21 bzw. 41 und insbesondere die Dichtheit desselben im Bereich des Anschlusses sowie der Anordnung des Anschlussgehäuses 28 bzw. 51 bzw. 62 sichergestellt bzw. zuverlässig aufrecht erhalten.

In dem schematischen Flussdiagramm von Fig. 6 erfolgt in einem Schritt S1 ein an sich bekannter Aufbau eines rückseitenkontaktierten photovoltaischen Moduls durch Kopplung von Solarzellen mit der jeweils strukturierten leitenden bzw. leitfähigen Schicht unter Einbettung in ein Kunststoffmaterial. Darüber hinaus erfolgt ein Verbinden mit dem Basis- bzw. Trägermaterial sowie die Anordnung der Abdeckschicht.

Nach einer Fertigstellung des photovoltaischen Moduls gemäß Schritt S1 erfolgt im Schritt S2 die Ausbildung wenigstens einer Durchtrittsöffnung in der Abdeckschicht zur Freilegung der Teilbereiche unterschiedlicher Polarität der leitenden und strukturierten Schicht.

Die Freilegung der wenigstens einen Durchtrittsöffnung in der Abdeckschicht kann durch ein mechanisches Entfernen eines entsprechenden Teilbereichs, ein Fräsen oder ein Ätzen insbesondere in der Abhängigkeit von dem Material der Abdeckschicht erfolgen.

Insbesondere bei Verwendung einer Verbundfolie, welche aus der Abdeckschicht und der leitenden bzw. leitfähigen Schicht besteht, wird ein Entfernen eines Teilbereichs der Abdeckschicht zur Ausbildung der Durchtrittsöffnung unter Einsatz eines Lasers vorgeschlagen.

Ein derartiger Schritt S2 einer Ausbildung der Durchtrittsöffnung unter Einsatz eines Lasers kann hierbei unter Verwendung folgender Parameter eines UV-Lasers erfolgen:
Gesamtleistung: 1,1 Watt
Punktgröße: 5,65 µm
Leistung: etwa 48 mJ pro Schuss

Nach einer derartigen Freilegung der Durchtrittsöffnung wird für eine Verbesserung der Kontaktierung ein Polieren ebenfalls unter Einsatz eines UV-Lasers vorgeschlagen, wobei folgende Parameter zum Einsatz gelangen:
Gesamtleitung: 0,8 Watt
Größe: 13,33 µm
Leistung: etwa 27 mJ pro Schuss

Anstelle eines UV-Lasers kann insbesondere in Abhängigkeit von dem Material der Abdeckschicht beispielsweise auch ein CO₂-Laser, insbesondere in einem mehrstufigen Verfahren zum Einsatz gelangen.

Darüber hinaus ist ein kombinierter Einsatz eines UV-Lasers und CO₂-Lasers zur Herstellung der Durchtrittsöffnung in der Abdeckschicht möglich.

Nach einem Freilegen der Teilbereiche unterschiedlicher Polarität unter Ausbildung wenigstens einer Durchtrittsöffnung in der Abdeckschicht gemäß dem Schritt S2 erfolgt gemäß Schritt S3 eine Aufbringung eines leitfähigen Klebers oder einer Lötpaste in den freigelegten Teilbereichen unterschiedlicher Polarität der strukturierten und leitfähigen Schicht des photovoltaischen Moduls.

Nachfolgend erfolgt durch ein Aufsetzen und Festlegen des Anschlussgehäuses gemäß Schritt S4, beispielsweise unter Verwendung eines Klebers, unmittelbar jeweils eine Kontaktierung von freien Enden der Anschlusselemente bei der Ausbildung gemäß Fig. 2 oder 4 oder unmittelbar der Anschlüsse des Anschlussgehäuses gemäß Fig. 5 im Bereich der wenigstens einen Durchtrittsöffnung mit den Teilbereichen unterschiedlicher Polarität der strukturierten und leitenden Schicht.

Das unter Bezugnahme auf Fig. 6 beschriebene Verfahren kann hierbei entsprechend automatisiert vorgenommen werden, so dass gegenüber dem bekannten Stand der Technik, wie er beispielsweise unter Bezugnahme auf Fig. 1 erörtert wurde, ein Kontaktieren eines photovoltaischen Moduls mit Anschlusselementen oder Anschlüssen eines Anschlussgehäuses unter stark verringertem Zeit- und somit Kostenaufwand bei insbesondere erhöhter Präzision durchgeführt werden kann. Darüber hinaus wird die Integrität bzw. Dichtheit des gemäß Schritt S1 fertig gestellten photovoltaischen Moduls nicht beeinträchtigt, da selbst im Bereich der Durchtrittsöffnung in der Abdeckschicht die erforderliche Abdichtung durch die darunter liegende Schicht aus strukturiertem leitendem Material aufrecht erhalten wird.

## Patentansprüche

1. Verfahren zum Kontaktieren eines photovoltaischen Moduls (21, 41) mit einem Anschlussgehäuse bzw. einer Junction Box (28, 51, 62), wobei zur Herstellung des photovoltaischen Moduls (21, 41) wenigstens eine Solarzelle (22, 42) an einer Rückseite mit einer elektrisch leitenden bzw. leitfähigen und strukturierten Schicht (24, 44) zur Ableitung der in der Solarzelle (22, 42) erzeugten elektrischen Energie gekoppelt wird und an der von der elektrisch leitenden Schicht (24, 44) abgewandten Oberfläche der Solarzelle (22, 42) wenigstens eine transparente Trägerschicht (23, 43) und an der elektrisch leitenden Schicht (24, 44) eine Abdeckschicht (27, 47) vorgesehen werden, wobei nachfolgend die elektrisch leitende und strukturierte Schicht (24, 44) mit Anschlüssen (30, 31, 49, 50, 61) des Anschlussgehäuses (28, 51, 62) kontaktiert wird, wobei nach der Fertigstellung des photovoltaischen Moduls (21, 41) beispielsweise durch ein Verpressen der und/oder eine Wärmeeinwirkung auf die das photovoltaische Modul (21, 41) bildenden Schichten bzw. Elemente (22, 23, 24, 26, 27; 42, 43, 44, 46, 47) in der Abdeckschicht (27, 47) wenigstens eine Durchtrittsöffnung (29, 48) für ein Freilegen von Teilbereichen unterschiedlicher Polarität (+, -) der strukturierten leitenden Schicht (24, 44) ausgebildet wird und Anschlüsse oder Anschlusselemente (30, 31, 49, 50, 61) des Anschlussgehäuses (28, 51, 62) direkt mit den Teilbereichen unterschiedlicher Polarität (+, -) der strukturierten leitenden Schicht (24, 44) gekoppelt werden, **dadurch gekennzeichnet, dass** die elektrisch leitende und strukturierte Schicht (24, 44) und die Abdeckschicht (27, 47) von einer Verbundfolie gebildet werden, welche mit der Solarzelle (22, 42) verbunden bzw. gekoppelt wird.

2. Verfahren nach Anspruch 1, **dadurch gekennzeichnet, dass** die wenigstens eine Durchtrittsöffnung (29, 48) durch ein mechanisches Entfernen eines Teilbereichs der Abdeckschicht (27, 47), ein Fräsen, ein Ätzen oder dgl. freigelegt wird.

3. Verfahren nach Anspruch 2, **dadurch gekennzeichnet, dass** das Ätzen unter Einsatz eines Lasers durchgeführt wird.

4. Verfahren nach einem der Ansprüche 1 bis 2 oder 3, **dadurch gekennzeichnet, dass** ein direktes Kontaktieren mit Anschlüssen oder Anschlusselementen (30, 31, 49, 50, 61) des Anschlussgehäuses (28, 51) durch ein Verlöten, Verkleben, oder dgl. durchgeführt wird.

5. Verfahren nach einem der Ansprüche 1 bis 4, **dadurch gekennzeichnet, dass** die Abdeckschicht (27, 47) von mindestens einer Kunststoffschicht, beispielsweise einer Polyvinylfluoridfolie, gebildet wird.

6. Verfahren nach einem der Ansprüche 1 bis 5, **dadurch gekennzeichnet, dass** die Positionierung des Anschlussgehäuses (28, 51, 62) auf der Abdeckschicht (27, 47) nach Ausbildung der wenigstens einen Durchtrittsöffnung (29, 48) automatisiert vorgenommen wird.

7. System bestehend aus einem photovoltaischen Modul (21, 41) und einem Anschlussgehäuse bzw. einer Junction Box (28, 51, 62), wobei das photovoltaische Modul (21, 41) wenigstens eine Solarzelle (22, 42) umfasst, welche an einer Rückseite mit einer elektrisch leitenden bzw. leitfähigen und strukturierten Schicht (24, 44) zur Ableitung der in einer Solarzelle (22, 42) erzeugten elektrischen Energie gekoppelt ist, und darüber hinaus an der von der elektrisch leitenden Schicht (24, 44) abgewandten Oberfläche der Solarzelle (22, 42) wenigstens eine transparente Trägerschicht (23, 43) und an der elektrisch leitenden Schicht (24, 44) eine Abdeckschicht (27, 47) vorgesehen sind, wobei die elektrisch leitende und strukturierte Schicht (24, 44) mit Anschlüssen (30, 31, 49, 50, 61) des Anschlussgehäuses (28, 51, 62) kontaktierbar ist, wobei Anschlüsse oder Anschlusselemente (30, 31, 49, 50, 61) des Anschlussgehäuses (28, 51, 62) direkt mit Teilbereichen unterschiedlicher Polarität (+, -) der strukturierten leitenden Schicht (24, 44) über wenigstens eine Durchtrittsöffnung (29, 48) in der Abdeckschicht (27, 47) koppelbar sind, **dadurch gekennzeichnet, dass** die elektrisch leitende Schicht (24, 44) und die Abdeckschicht (27, 47) von einer Verbundfolie gebildet sind.

8. System nach Anspruch 7, **dadurch gekennzeichnet, dass** die Anschlüsse (31, 50) des Anschlussgehäuses (28, 51) mit jeweils einem leitenden Element (30, 49) koppelbar sind, welches insbesondere über eine Klebe- bzw. Lötverbindung mit jeweils einem Teilbereich unterschiedlicher Polarität (+, -) der strukturierten leitenden (24, 44) Schicht durch die Durchtrittsöffnung (29, 48) kontaktierbar und damit koppelbar ist.

9. System nach Anspruch 8, **dadurch gekennzeichnet, dass** das leitende Element (30, 49) von einem aus einem leitenden Material gebildeten Element, insbesondere einem Lötbändchen, oder dgl. gebildet ist.

10. System nach Anspruch 7, 8 oder 9, **dadurch gekennzeichnet, dass** die Anschlüsse (61) des Anschlussgehäuses (62) direkt mit jeweils einem Teilbereich unterschiedlicher Polarität (+, -) der strukturierten leitenden Schicht (44) durch die Durchtrittsöffnung (48) kontaktierbar und damit koppelbar sind.

11. System nach einem der Ansprüche 7 bis 10, **dadurch gekennzeichnet, dass** das Anschlussgehäuse (28, 51, 62) an dem photovoltaischen Modul (21, 41) dichtend, insbesondere über eine Verklebung (52, 65) festlegbar ist.

## Claims

1. A method for contact-connecting a photovoltaic module (21, 41) to a connection housing or junction box (28, 51, 62), wherein, for producing the photovoltaic module (21, 41), at least one solar cell (22, 42) is coupled on a rear side to an electrically conducting or conductive and structured layer (24, 44) for conducting away the electrical energy generated in the solar cell (22, 42), and at least one transparent carrier layer (23, 43) is provided on the surface of the solar cell (22, 42) facing away from the electrically conducting layer (24, 44) and a covering layer (27, 47) is provided on the electrically conducting layer (24, 44), wherein the electrically conducting and structured layer (24, 44) is subsequently contact-connected to connections (30, 31, 49, 50, 61) of the connection housing (28, 51, 62), wherein, after the completion of the photovoltaic module (21, 41) for instance by compression and/or heat exposure of the layers or elements (22, 23, 24, 26, 27; 42, 43, 44, 46, 47) forming the photovoltaic module (21, 41), at least one through-opening (29, 48) for exposing partial regions having different polarities (+, -) of the structured conducting layer (24, 44) is formed in the covering layer (27, 47), and connections or connection elements (30, 31, 49, 50, 61) of the connection housing (28, 51, 62) are directly coupled to said partial regions having different polarities (+, -) of the structured conducting layer (24, 44), **characterized in that** the electrically conducting and structured layer (24, 44) and the covering layer (27, 47) are formed by a compound film which is connected or coupled to the solar cell (22, 42).

2. A method according to claim 1, **characterized in that** the at least one through-opening (29, 48) is exposed by mechanically removing a partial region of the covering layer (27, 47), by milling, etching, or the like.

3. A method according to claim 2, **characterized in that** etching is performed by using a laser.

4. A method according to any one of claims 1 to 2 or 3, **characterized in that** direct contact-connecting to connections or connection elements (30, 31, 49, 50, 61) of the connection housing (28, 51) is effected by solder bonding, adhesive bonding, or the like.

5. A method according to any one of claims 1 to 4, **characterized in that** the covering layer (27, 47) is comprised of at least one synthetic layer, e.g. a polyvinylfluoride film.

6. A method according to any one of claims 1 to 5, **characterized in that** the positioning of the connection housing (28, 51, 62) on the covering layer (27, 47) is effected automatically after the formation of the at least one through-opening (29, 48).

7. A system consisting of a photovoltaic module (21, 41) and a connection housing or junction box (28, 51, 62), wherein the photovoltaic module (21, 41) comprises at least one solar cell (22, 42) which is coupled on a rear side to an electrically conducting or conductive and structured layer (24, 44) for conducting away the electrical energy generated in a solar cell (22, 42) and, furthermore, at least one transparent carrier layer (23, 43) is provided on the surface of the solar cell (22, 42) facing away from the electrically conducting layer (24, 44), and a covering layer (27, 47) is provided on the electrically conducting layer (24, 44), wherein the electrically conducting and structured layer (24, 44) can be contact-connected to connections (30, 31, 49, 50, 61) of the connection housing (28, 51, 62), wherein connections or connection elements (30, 31, 49, 50, 61) of the connection housing (28, 51, 62) can be directly coupled to partial regions having different polarities (+, -) of the structured conducting layer (24, 44) via at least one through-opening (27, 47) in the covering layer (27, 47), **characterized in that** the electrically conducting layer (24, 44) and the covering layer (27, 47) are formed by a compound film.

8. A system according to claim 7, **characterized in that** the connections (31, 50) of the connection housing (28, 51) are each coupleable to a conducting element (30, 49), which is each contact-connectable, and hence coupleable, to a partial region of different polarity (+, -) of the structured conducting layer (24, 44) via the through-opening (29, 48), particularly by an adhesive or solder bond.

9. A system according to claim 8, **characterized in that** the conducting element (30, 49) is comprised of an element made of a conducting material, in particular a solder strip, or the like.

10. A system according to claim 7, 8 or 9, **characterized in that** the connections (61) of the connection housing (62) are each directly contact-connectable, and hence coupleable, to a partial region of different polarity (+, -) of the structured conducting layer (44) via the through-opening (48).

11. A system according to any one of claims 7 to 10, **characterized in that** that the connection housing (28, 51, 62) is sealingly fixable to the photovoltaic module (21, 41), particularly by an adhesive bond (52, 65).

## Revendications

1. Procédé de mise en contact électrique d'un module photovoltaïque (21, 41) avec un boîtier de raccordement ou une boîte de jonction (28, 51, 62), au moins une cellule solaire (22, 42), pour la production du module photovoltaïque (21, 41), étant, au dos, couplée à une couche (24, 44) conduisant ou susceptible de conduire l'électricité et structurée afin d'évacuer l'énergie électrique produite dans la cellule solaire (22, 42) et, sur la face opposée à la couche (24, 44) conduisant l'électricité de la cellule solaire (22, 42), il est prévu au moins une couche porteuse (23, 43) transparente, et, sur la couche (24, 44) conduisant l'électricité, une couche de recouvrement (27, 47), la couche (24, 44) conduisant l'électricité et structurée pouvant être mise en contact électrique avec des raccordements (30, 31, 49, 50, 61) du boîtier de raccordement (28, 51, 62), au moins une ouverture de passage (29, 48) pour une mise à nu de parties de polarité opposée (+, -) de la couche conductrice structurée (24, 44) étant ménagée dans la couche de recouvrement (27, 47) une fois le module photovoltaïque (21, 41) fabriqué, par exemple par un assemblage par pression des couches ou éléments (22, 23, 24, 26, 27 ; 42, 43, 44, 46, 47) formant le module photovoltaïque (21, 41) ou un effet thermique sur ces couches ou éléments, et des raccordements ou éléments de raccordement (30, 31, 49, 50, 61) du boîtier de raccordement (28, 51, 62) étant couplés directement aux parties de polarité opposée (+, -) de la couche (24, 44) conductrice structurée, **caractérisé en ce que** la couche conduisant l'électricité et structurée (24, 44) et la couche de recouvrement (27, 47) sont formées par un film composite, lequel est relié ou couplé à la cellule solaire (22, 42).

2. Procédé selon la revendication 1, **caractérisé en ce que** l'ouverture ou les ouvertures de passage (29, 48) sont mises à nu par une élimination mécanique d'une partie de la couche de recouvrement (27, 47), un fraisage, une gravure ou similaire.

3. Procédé selon la revendication 2, **caractérisé en ce que** la gravure est mise en oeuvre au moyen d'un laser.

4. Procédé selon l'une quelconque des revendications 1 à 2 ou 3, **caractérisé en ce qu'**une mise en contact électrique directe avec des raccordements ou des éléments de raccordement (30, 31, 49, 50, 61) du boîtier de raccordement (28, 51) est mise en oeuvre par brasage, collage ou similaire.

5. Procédé selon l'une quelconque des revendications 1 à 4, **caractérisé en ce que** la couche de recouvrement (27, 47) est formée par au moins une couche de matière plastique, par exemple par un film de fluorure de polyvinyle.

6. Procédé selon l'une quelconque des revendications 1 à 5, **caractérisé en ce que** le positionnement du boîtier de raccordement (28, 51, 62) sur la couche de recouvrement (27, 47) est mis en oeuvre de manière automatique après la formation de l'ouverture ou des ouvertures de passage (29, 48).

7. Système se composant d'un module photovoltaïque (21, 41) et d'un boîtier de raccordement ou d'une boîte de jonction (28, 51, 62), le module photovoltaïque (21, 41) comprenant au moins une cellule solaire (22, 42) qui, au dos, est couplée à une couche (24, 44) conduisant ou susceptible de conduire l'électricité et structurée afin d'évacuer l'énergie électrique produite dans une cellule solaire (22, 42), et en outre, sur la face opposée à la couche (24, 44) conduisant l'électricité de la cellule solaire (22, 42), il est prévu au moins une couche porteuse (23, 43) transparente, et, sur la couche (24, 44) conduisant l'électricité, une couche de recouvrement (27, 47), la couche (24, 44) conduisant l'électricité et structurée pouvant être mise en contact électrique avec des raccordements (30, 31, 49, 50, 61) du boîtier de raccordement (28, 51, 62), des raccordements ou éléments de raccordement (30, 31, 49, 50, 61) du boîtier de raccordement (28, 51, 62) pouvant être couplés directement à des parties de polarité opposée (+, -) de la couche (24, 44) conductrice structurée en passant par au moins une ouverture de passage (29, 48) dans la couche de recouvrement (27, 47), **caractérisé en ce que** la couche conduisant l'électricité (24, 44) et la couche de recouvrement (27, 47) sont formées par un film composite.

8. Système selon la revendication 7, **caractérisé en ce que** les raccordements (31, 50) du boîtier de raccordement (28, 51) peuvent être couplés à respectivement un élément conducteur (30, 49), lequel peut être mis en contact électrique et donc couplé à respectivement une partie de polarité opposée (+, -) de la couche (24, 44) structurée conductrice en passant par l'ouverture de passage (29, 48).

9. Système selon la revendication 8, **caractérisé en ce que** l'élément conducteur (30, 49) est formé par un élément composé d'un matériau conducteur, en particulier un petit ruban de métal d'apport, ou similaire.

10. Système selon la revendication 7, 8 ou 9, **caractérisé en ce que** les raccordements (61) du boîtier de raccordement (62) peuvent être mis en contact électrique et donc couplés directement avec respectivement une partie de polarité opposée (+, -) de la couche (44) structurée conductrice en passant par l'ouverture de passage (48).

11. Système selon l'une quelconque des revendications 7 à 10, **caractérisé en ce que** le boîtier de raccordement (28, 51, 62) peut être fixé de manière étanche sur le module photovoltaïque (21, 41), en particulier au moyen d'un collage (52, 65).
